Europäisches Patentamt

European Patent Office

Office européen des brevets

(11) Publication number: **0 186 524 B1**

# EUROPEAN PATENT SPECIFICATION

(45) Date of publication of patent specification: **13.03.91**  (51) Int. Cl.⁵: **H02M 1/14**

(21) Application number: **85309534.7**

(22) Date of filing: **30.12.85**

(54) Line filter.

(30) Priority: **28.12.84 JP 277716/84**
**29.08.85 JP 190112/84**
**31.08.85 JP 192879/84**

(43) Date of publication of application:
**02.07.86 Bulletin 86/27**

(45) Publication of the grant of the patent:
**13.03.91 Bulletin 91/11**

(84) Designated Contracting States:
**DE GB IT NL**

(56) References cited:
**GB-A- 2 146 497**

**IBM TECHNICAL DISCLOSURE BULLETIN, vol. 23, no. 12, May 1981, pages 5439-5440, New York, US; C.J. PALMUCCI et al.: "Combined EMI and smoothing filter for TSR AC/DC stage"**

(73) Proprietor: **KABUSHIKI KAISHA TOSHIBA**
**72, Horikawa-cho Saiwai-ku**
**Kawasaki-shi Kanagawa-ken 210(JP)**

(72) Inventor: **Okochi, Sadao, Kabushiki Kaisha Toshiba**
**c/o Patent Division 1-1 Shibaura, 1-chome Minato-ku Tokyo(JP)**

(74) Representative: **Freed, Arthur Woolf et al**
**MARKS & CLERK 57-60 Lincoln's Inn Fields London WC2A 3LS(GB)**

Rank Xerox (UK) Business Services

## Description

The present invention relates to a line filter for reducing so-called normal mode and common mode noise generated during the use of a switching power source unit.

In general, when a switching power source is used as a power source unit for electronic equipment, so-called conduction noise is generated, This conduction noise can cause operation failures in the electronic equipment.

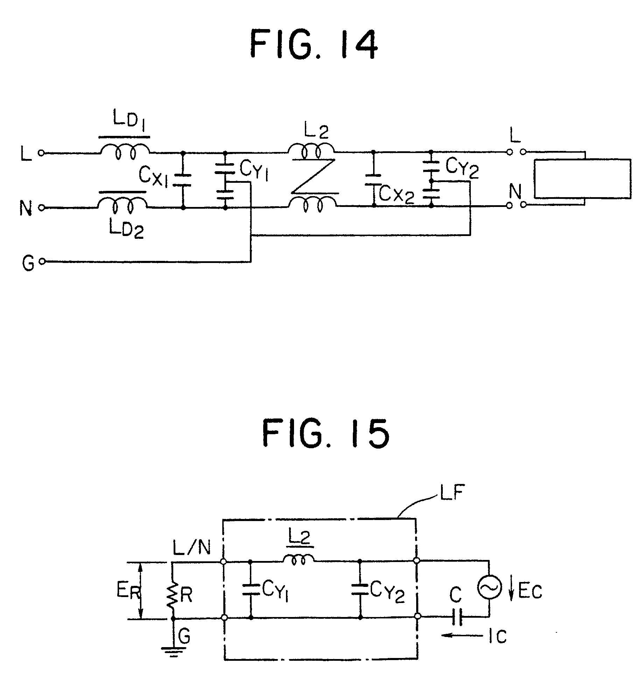

The conduction noise consists of two components: common mode noise (identical phase noise) and normal mode noise (differential noise). In conventional electronic equipment, a line filter as shown in Fig. 14 is connected to the input terminal of a switching power source unit to reduce these noise components. The IBM Technical Disclosure Bulletin Vol.23 No.12, May 1981, p. 5439-5440 discloses a similar filter in an arrangement using coupled choke coils and connected at the dc input side of a switching power source.

Referring to Fig. 14, reference symbols $LD_1$ and $LD_2$ denote choke coils which comprise two insulated coils; $L_2$ denotes a balun (i.e., a balance to unbalance transformer) type choke coil; $C_{X1}$ and $C_{X2}$. capacitors inserted between lines L and N; and $C_{Y1}$ and $C_{Y2}$. capacitors inserted between the lines L and N and ground. The capacitors $C_{Y1}$ and $C_{Y2}$ each consist of two capacitors. In general, a capacitor inserted between the lines is called an X capacitor, and a capacitor inserted between the lines and ground is called a Y capacitor.

In the line filter with the arrangement described above, the insulated coils $LD_1$ and $LD_2$ work with the X capacitors $C_{X1}$ and $C_{X2}$ to eliminate normal mode noise generated between the lines (to be referred to as the L - N path hereinafter). The balun $L_2$ works with the Y capacitors $C_{Y1}$ and $C_{Y2}$ to eliminate common mode noise generated between the lines and ground (to be referred to as the L/N - G path hereinafter).

When capacitances of the X capacitors $C_{X1}$ and $C_{X2}$ are increased, normal mode noise can be almost eliminated since normal mode noise has a low level. Common mode noise, however, cannot be easily reduced due to the following reason.

Fig. 15 is an equivalent circuit diagram prepared for explaining common mode noise in consideration of a load noise source and an equivalent impedance R for input lines L and N.

Referring to Fig. 15, a reference symbol $E_C$ denotes a voltage generated as a noise source; and $E_R$. a noise voltage appearing between the line L/N and ground G.

The noise source voltage $E_C$ is generated mainly upon variations in potential at a power transistor in the switching power source unit. When the voltage $E_C$ is applied to the primary winding of a transformer (not shown) in the power source unit, a noise current $I_C$ flows to the ground terminal due to the behavior of a capacitor C inserted between the primary winding and ground. The noise current $I_C$ flows through the line filter LF and is fed back to the switching power source unit.

In this case, since the impedance R is present at the line input side of the switching power source unit, the noise voltage $E_R$ appears. This is defined as common mode noise.

The noise voltage $E_R$ can be substantially eliminated when the inductance of the choke coil $L_2$ and the capacitance of the Y capacitors $C_{Y1}$ and $C_{Y2}$ are increased. However, the grounded current $I_C$ must be as low as about several milliamperes for safe circuit operation. Therefore, the capacitances of the Y capacitors $C_{Y1}$ and $C_{Y2}$ inevitably have upper limits.

Necessary attenuation must be guaranteed by increasing the inductance of the coil $L_2$. When the inductance of the coil $L_2$ is increased, its size increases accordingly, and this results in higher cost than would an increase in the capacitance of the Y capacitor.

The noise voltage $E_R$, i.e., common mode noise, cannot therefore be easily eliminated by conventional line filters.

It is an object of the present invention to provide a low-cost line filter wherein the upper capacitance of a Y capacitor can be properly limited and common mode noise can be eliminated without increasing the size of a choke coil.

It is another object of the present invention to provide a line filter which can effectively prevent leakage of common mode noise from a load through an input side.

It is still another object of the present invention to provide a line filter wherein the leakage current is small and predetermined attenuation can be obtained.

In order to achieve the above objects of the present invention, there is provided a line filter to be used in an electronic apparatus having an AC input unit and a switching power source unit, comprising: a first choke coil inserted between lines at an input side of the line filter; a second choke coil inserted between the lines at a load side of the line filter; first Y capacitors inserted between the lines and ground at an output side of the first choke coil; a first X capacitor inserted between the lines; second Y capacitors inserted between the lines and ground at an output side of the second choke coil; and a second X capacitor inserted between the lines at a load side of the second choke coil, wherein the first and second choke coils comprise baluns and the second choke coil has an inductance larger than that of the first choke coil.

Fig. 1 is a circuit diagram of a line filter according to an embodiment of the present invention;

Figs. 2, 3, and 5 are equivalent circuit diagrams for the line filter in Fig. 1;

Fig. 4 is a graph showing attenuation characteristics of the circuits in Figs. 2 and 3;

Fig. 6 is a schematic diagram of an electronic apparatus as an application employing the line filter in Fig. 1;

Figs. 7, 8, and 9 are block diagrams showing the circuit arrangement of the unit in Fig. 6;

Figs. 10, 11, and 12 are circuit diagrams showing modifications of the circuits in Figs. 7 and 8;

Fig. 13 is a circuit diagram showing a modification of the present invention;

Fig. 14 is a circuit diagram of a conventional line filter; and

Fig. 15 is an equivalent circuit diagram arranged in accordance with a main feature of the line filter in Fig. 14.

A line filter according to an embodiment of the present invention will be described with reference to the accompanying drawings.

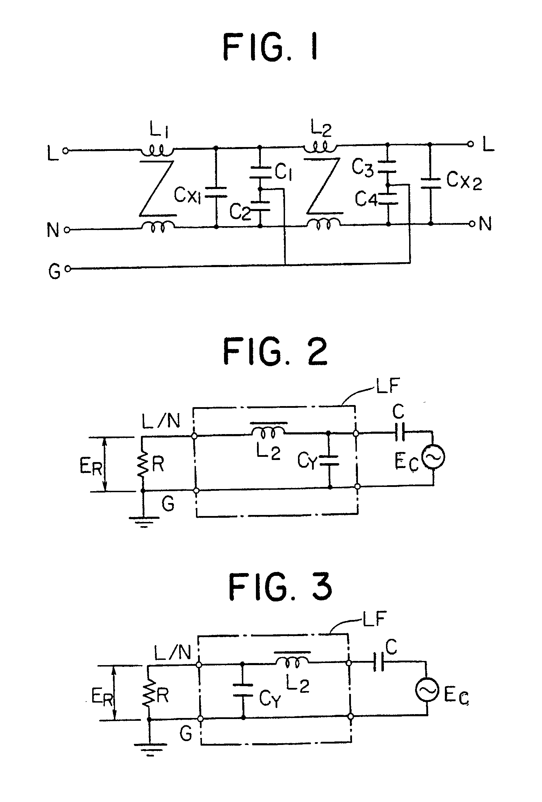

Fig. 1 is a circuit diagram of a line filter according to an embodiment of the present invention. The same reference numerals in Fig. 1 denote the same parts as in Figs. 14 and 15.

Referring to Fig. 1, a choke coil (to be referred to as a balun hereinafter) $L_1$ has a small distributed capacitance obtained by decreasing its inductance. A second balun $L_2$ has an inductance larger than that of the first balun $L_1$. X capacitors $C_{X1}$ and $C_{X2}$ are connected in the L - N path. Capacitors $C_1$, $C_2$, $C_3$, and $C_4$ serve as Y capacitors in the L/N - G path. The sum of the capacitances of the Y capacitors $C_1$ and $C_2$ is larger than that of the Y capacitors $C_3$ and $C_4$.

Assume that the line filter in this embodiment is used together with a 50-kHz switching power source unit and that an attenuation of 100 dB is guaranteed against 50-kHz noise. As a result, the inductances and capacitances of the line filter must be set as follows:

$L_1$ = 2 mH

Leakage inductance of $L_1$ = 15 $\mu$H

$L_2$ = 30 mH

Leakage inductance of $L_2$ = 0.5 mH

$C_{X1}$ = 0.3 $\mu$F

$C_{X2}$ = 0.2 $\mu$F

$C_1$ = $C_2$ = 9,400 pF

$C_3$ = $C_4$ = 4,700 pF

The steps which led to the design of the line filter of this embodiment will be reviewed hereinafter.

Since the line filter in Fig. 1 has both X and Y capacitors, both normal mode noise and common mode noise can be eliminated. As described above, normal mode noise can be easily eliminated, so common mode noise reduction will be concentrated on below.

Figs. 2 and 3 show different filter circuits having Y capacitors $C_Y$ inserted in different positions to determine which circuit is more suitable as a common mode noise reduction filter.

Referring to Figs. 2 and 3, a reference symbol $E_C$ denotes a voltage generated as a noise source; $E_R$, a noise voltage appearing in the L/N - G path; C, the capacitance between ground and the primary winding of a transformer (not shown) in a switching power source unit; and P, an equivalent impedance for the noise source and the input line.

When an attenuation (IL) is defined as:

IL = $20\log_{10}(E_C/E_R)$ (dB) the filter in Fig. 2 has an attenuation IL($\omega$) given as:

$$IL(\omega) = 20\log\sqrt{(1 + C_Y/C)^2 + (1/\omega_0 CR)^2 \{ (\omega/\omega_0)^2 - (\omega_0/\omega)^2 \}^2}$$

where $\omega_0$ is the resonant frequency corresponding to an abrupt drop in the attenuation and is defined as:

$$\omega_0 = 1/\sqrt{L_2 (C_Y + C)}$$

On the other hand, the filter in Fig. 3 has an attenuation IL($\omega$) given as:

$$IL(\omega) = 20\log\sqrt{(1 + C_Y/C - \omega^2 L_2 C_Y)^2 + (\omega L_2/R - 1/\omega CR)^2}$$

wherein the resonant frequency $\omega_1$ is given as:

$$\omega_1 = 1/\sqrt{L_2\{C_Y C/(C_Y + C)\}}$$

In this case, if $\omega = \omega_1$, the attenuation can be derived as follows:

$$IL(\omega_1) = 20\log\sqrt{(1/\omega_1 C_Y R)}$$

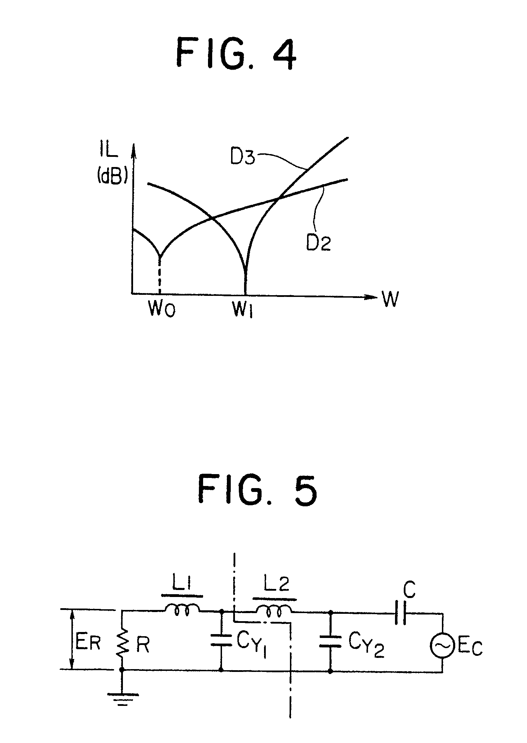

The attenuation characteristics of the filter circuits of Figs. 2 and 3 will be described with reference to Fig. 4.

Fig. 4 is a graph showing the results given by the equations described above for explaining the relationship between frequency and attenuation in the filters in Figs. 2 and 3. Referring to Fig. 4, a reference symbol $D_2$ denotes an attenuation characteristic curve of the filter in Fig. 2; and $D_3$, an attenuation characteristic curve of the filter in Fig. 3.

The calculations were done for the filters under the following conditions:

$L_2 = 30$ mH

$C_Y = 28$ nF

$C = 35$ pF

$R = 50$ Ω

As is apparent from Fig. 4, since the filter in Fig. 2 causes the attenuation of the choke coil $L_2$ to drop slightly, this filter is advantageous in guaranteeing attenuation in relatively low frequency ranges.

When the capacitance $C_Y$ and the inductance $L_2$ are given as:

$C_Y = 28$ nF

$L_2 = 30$ mH an attenuation of 100 dB against 50-kHz noise can be guaranteed at a switching frequency of 50 kHz. In this case, the choke coil, having a comparatively large inductance of 30 mH, is preferably constituted by a balun.

Since the core in the balun is not saturated by a differential current, a large inductance can be used for a noise voltage of an identical phase while a load current is flowing therethrough. However, a balun with a large inductance necessarily has a large number of turns and a large distributed capacitance. Such a balun cannot serve as a choke coil in the high frequency range cf 1 MHz to 30 MHz. As a result, attenuation may drop.

In order to prevent this, the balun $L_1$ shown in Fig. 5 is added.

The balun $L_1$ has a low inductance and a low distributed capacitance.

The attenuation $IL(\omega)$ of the filter in Fig. 5 is given as:

$$IL(\omega) = 20\log\sqrt{[SQ + (S + 1)\{1 - (\omega/\omega_R)^2 Q\}]^2 + [PQ/\omega CR \times (1 + 1/S)\{[(\omega/\omega_R)^2 - A]^2 + B - A^2\}]^2}$$

where

$P = L_1/L_2$

$Q = C_{Y1}/C_{Y2}$

$S = C_{Y2}/C$

$A = [\{(Q + 1) + (1/S)\}/Q\{1 + (1/S)\} + 1/PQ]/2$

$R = 1/[PQ\{1 + (1/S)\}]$

4

$\omega_R^2 = 1/L_2C_{Y2}$

The attenuation of the filter in Fig. 5 at different frequencies was calculated, and a combination of capacitances $C_{Y1}$ and $C_{Y2}$ for maximizing attenuation at 50 kHz to 60 kHz was calculated. If the following conditions

$L_1 = 2$ mH
$L_2 = 30$ mH
$C = 35$ pF
$R = 50$ Ωhold true, then
$C_{Y1} = 18.8$ nF
$C_{Y2} = 9.4$ nF are suitable under the condition:
$C_{Y1} + C_{Y2} = 28$ nF

In the case described above, the sum of the Y capacitors $C_{Y1}$ and $C_{Y2}$ is 28.2 nF. However, since the capacitance of commercially available capacitors is not continuous, the above combination is optimal.

When the inductances of the baluns are inverted, i.e., when $L_1 = 30$ mH and $L_2 = 2$ mH, and the capacitors $C_{Y1}$ and $C_{Y2}$ vary under the condition

$C_{Y1} + C_{Y2} = 28$ nF the attenuation at the frequency range of 50 kHz to 60 kHz drops considerably.

In this manner, when the inductance of the balun $L_1$ is significantly larger than that of the balun $L_2$, a lower peak of the attenuation IL occurs in the attenuation frequency band. Therefore, the inductance of the balun $L_1$ must be smaller than that of the balun $L_2$. The above test results provide the following conditions:

$L_1 = 2$ mH
$L_2 = 30$ mH
$C_{Y1} = 18.8$ nF
therefore,
$C_1 = C_2 = 9,400$ pF
$C_{Y2} = 9.4$ nF
therefore,
$C_3 = C_4 = 4,700$ pF The filter in Fig. 1 is thus obtained.

When the filter of this embodiment is connected to the primary coil of the switching power source unit, a smoothing capacitor is inserted in parallel with the primary coil.

The capacitances of the X capacitors $C_{X1}$ and $C_{X2}$ are determined in accordance with the capacitance of the smoothing capacitor.

In this embodiment, the capacitances of the capacitors $C_{X1}$ and $C_{X2}$ are given as:

$C_{X1} = 0.3 \ \mu F, C_{X2} = 0.2 \ \mu F$

When the leakage inductances of the baluns $L_1$ and $L_2$ are increased, normal mode noise can be virtually eliminated by the X capacitor combination of $C_{X1}$ and $C_{X2}$.

The balun leakage inductances are determined by the capacitance of the smoothing capacitor inserted at the primary coil side of the switching power source unit in the same manner as the capacitances of the X capacitors.

In this embodiment, the leakage inductances are set by the predetermined mathematical expressions:

Leakage inductance of $L_1 = 15 \ \mu H$
Leakage inductance of $L_2 = 0.5$ mH

In the line filter in Fig. 1, when the baluns $L_1$ and $L_2$ are arranged adjacent to each other, a common mode noise current from the switching power source unit flows in the balun $L_2$. A magnetic flux is generated by the balun $L_2$ and is coupled to the balun $L_1$, thereby inducing a voltage at the balun $L_1$. The common mode noise current produced by the induction voltage causes a stray capacitance on the input side. As a result, common mode noise leaks outside the apparatus.

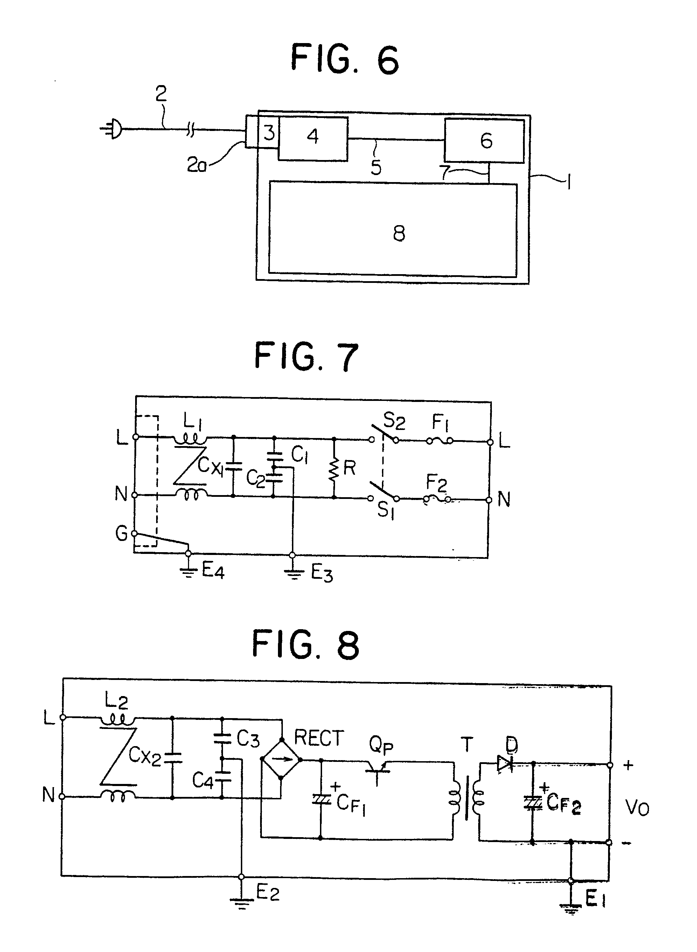

An application for preventing common mode noise leakage will be described in detail with reference to Figs. 6 to 12. The same reference numerals in Figs. 6 to 12 denote the same parts as in Fig. 1.

Fig. 6 shows an arrangement of an electronic apparatus with a line filter as an application of the present invention.

Referring to Fig. 6, the electronic apparatus has a housing 1, a power cord 2 one end of which has a plug and the other end of which has a cord connector, 2a, an inlet 3 to be connected to the connector 2a, an AC input unit 4, a switching power source unit 6, a data processing unit 8, and internal wirings 5 and 7 for connecting the units.

The AC input unit 4 is arranged near the inlet 3, through which a portion of the power cord 2 extends into the housing 1. The AC input unit 4 is thus separated from the switching power source unit 6. The two units are connected via the internal wiring 5.

In the apparatus having the arrangement described above, the line filter in Fig. 1 is divided into front

EP 0 186 524 B1

and rear stages. The front stage is mounted in the AC input unit 4, and the rear stage is mounted in the switching power source unit 6.

The arrangement of the front stage will be described with reference to Fig. 7.

In the front stage, a balun $L_1$ serves as a choke coil having a ring core and two coils with an identical phase. A capacitor $C_{X1}$ is inserted in the L - N path. Capacitors $C_1$ and $C_2$ are inserted in the L/N - G path. A resistor R is inserted in the L - N path. Switches $S_1$ and $S_2$ are inserted in the lines N and L, respectively. Fuses $F_1$ and $F_2$ are inserted in the lines L and N, respectively.

The arrangement of the rear stage will be described with reference to Fig. 8.

In the rear stage, a balun $L_2$ serves as a choke coil having a ring core and two coils with an identical phase, just as the balun $L_1$. A capacitor $C_{X2}$ is inserted in the L - N path. Capacitors $C_3$ and $C_4$ are inserted in the L/N - G path.

Since the rear stage is mounted in the switching power source unit, the arrangement of the switching power source unit will now be briefly described.

A rectifier Rect rectifies an AC voltage to a DC voltage. The DC voltage is smoothed by a smoothing capacitor $C_{F1}$. The emitter-collector path of a switching transistor $Q_p$ is inserted in one of the lines and is switched in response to a control signal from a control circuit (not shown). A rectifying diode $D_1$ rectifies a switching AC voltage induced at the secondary winding of a converter transformer T to obtain a DC voltage. The DC voltage is smoothed by a smoothing capacitor $C_{F2}$. The switching transistor $Q_p$ is switched to extract a DC output voltage Vo across the positive and negative terminals.

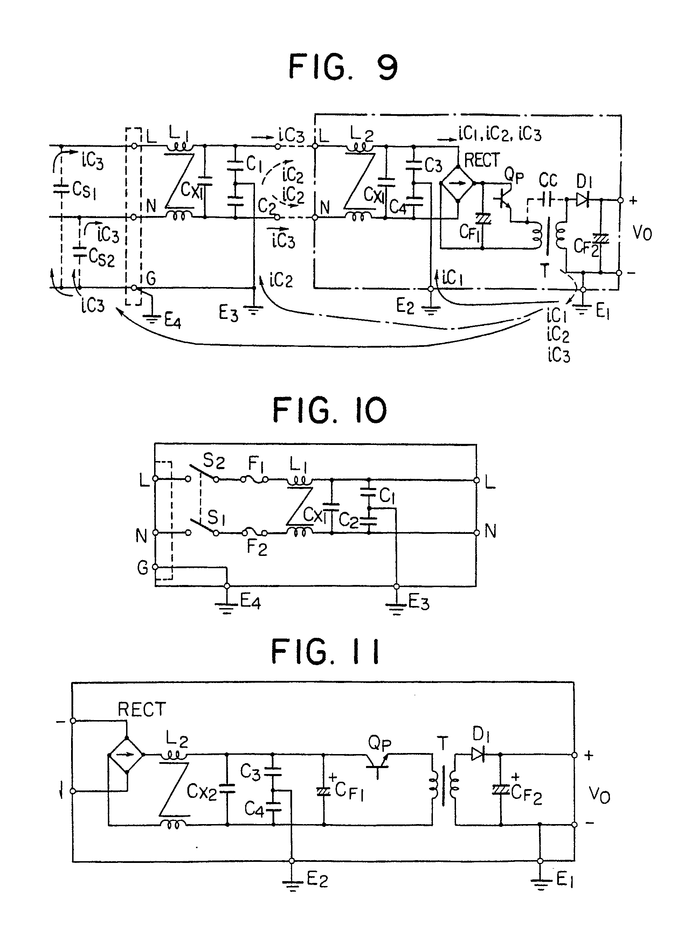

The front and rear stages are connected via an internal wiring to obtain a line filter function. The operation of the line filter as an application of the present invention will be described with reference to Fig. 9.

The common mode noise generated upon switching of the switching transistor $Q_p$ appears as a common mode noise current at the secondary winding of the converter transformer T through a stray capacitance Cc of the transformer T. The common mode noise current flown to a ground connecting point $F_1$ and flows into the circuit from primary winding ground connecting points $E_2$, $E_3$, and $E_4$ of the converter transformer T through chassis ground metal and ground lines.

Assume that common mode noise current components flowing from the ground connecting points $E_2$, $E_3$, and $E_4$ are defined as $i_{c1}$, $i_{c2}$, and $i_{c3}$, respectively. The common mode noise current component $i_{c1}$ returns to the switching power source unit through the Y capacitors $C_3$ and $C_4$. The noise component $i_{c2}$ returns to the line filter through the Y capacitors $C_1$ and $C_2$. The noise component $i_{c3}$ flows out of the line filter through the power cord 2 and returns thereto through stray capacitances $C_{S1}$ and $C_{S2}$. These stray capacitances are formed between ground and the power cord 2, interior wiring, or the like.

From the noise attenuation behavior of the line filter, it is clear that the noise current components have the following relationship:

$$| i_{c1} | > | i_{c2} | > | i_{c3} |$$

In this application, the path (a network consisting of the switching power source unit and the Y capacitors $C_3$ and $C_4$) of the largest switching noise current (i.e., $i_{c1}$) is shortened, and the network is spaced apart from the balun $L_1$. As a result, the leakage flux caused by the current $i_{c1}$ can be decreased, and hence common mode noise can be eliminated.

Furthermore, since the baluns $L_1$ and $L_2$ are spaced apart from each other at a predetermined distance, the magnetic flux from the balun $L_2$ due to the current $i_{c2}$ is not coupled to the balun $L_1$, and common mode noise can again be eliminated.

In the application described above, the switches $S_1$ and $S_2$ and the fuses $F_1$ and $F_2$ of the front stage are inserted between the resistor P and the output terminals of the front stage, but the application is not limited to that arrangement. For example, as shown in Fig. 10, the switches $S_1$ and $S_2$ and the fuses $F_1$ and $F_2$ may be inserted between the input terminals of the front stage and the balun $L_1$.

In the application described above, the rear stage of the line filter is inserted between the input terminal of the rear stage and the rectifier Rect, as shown in Fig. 8. However, as shown in Fig. 11, the rear stage may be inserted between the rectifier Rect and the switching power source unit.

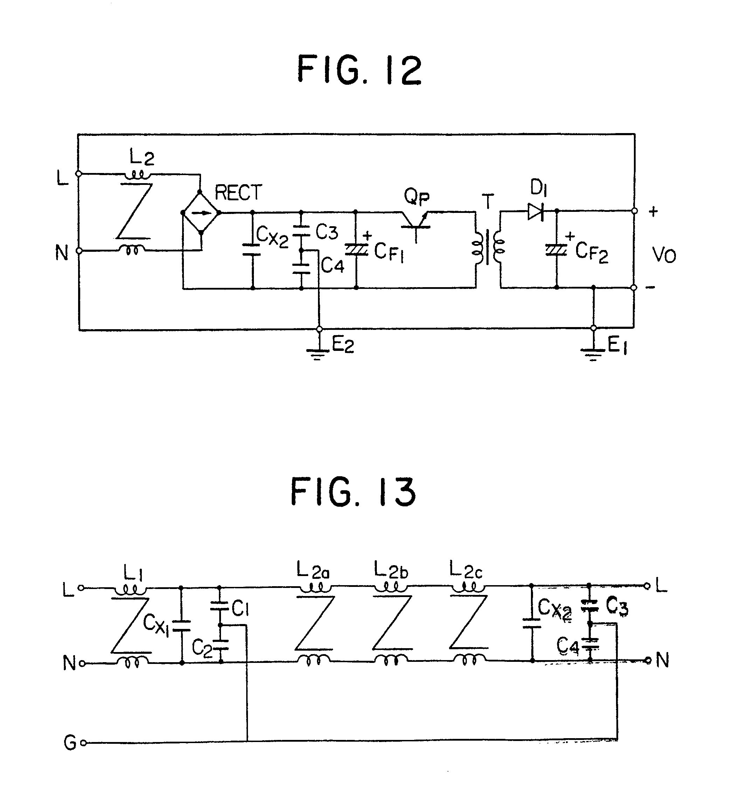

In the application described above, the Y capacitors $C_3$ and $C_4$ and the X capacitor $C_{X2}$ are inserted between the choke coil $L_2$ and the rectifier Rect, as shown in Fig. 8. However, as shown in Fig. 12, the Y capacitors $C_3$ and $C_4$ and the X capacitor $C_{X2}$ may be inserted in the line path between the rectifier Rect and the switching power source unit.

In the line filter shown in Fig. 1, assume that a leakage current $I_L$ must be reduced to, e.g., less than 1 mA. In this case, the capacitances of the Y capacitors must be about 8 nF. In order to obtain the same attenuation as previously described with reference to Fig. 1, the inductance of the balun $L_2$ must be tripled.

In order to obtain a balun with such a high inductance, the number of turns in the winding must be

6

increased, and the distributed capacitance can no longer be ignored. Therefore, the impedance is decreased in the low-frequency range of 10 kHz to 1 MHz, thereby impairing filter functioning. In order to avoid this, the following arrangement is proposed as a modification of the present invention.

Fig. 13 is a circuit diagram of a modification of the present invention designed to solve the above problem. The same reference numerals in Fig. 13 denote the same parts as in Fig. 1.

Referring to Fig. 13, a choke coil $L_1$ is constituted by a balun with a small distributed capacitance obtained by decreasing its inductance. Choke coils $L_{2a}$, $L_{2b}$, and $L_{2c}$ are constituted by baluns and are connected in series with each other. The sum of their inductances is larger than that of the balun $L_1$. Capacitors $C_{X1}$ and $C_{X2}$ are X capacitors inserted in the L - N path. Capacitors $C_1$, $C_2$, $C_3$, and $C_4$ are Y capacitors inserted in the L/N - G path. It should be noted that the sum of the capacitances of the Y capacitors $C_1$ and $C_2$ is larger than that of the Y capacitors $C_3$ and $C_4$.

In the line filter having the arrangement described above, the inductances of the baluns $L_{2a}$, $L_{2b}$, and $L_{2c}$ are small, so the number of turns and hence the distributed capacitance of the winding in each are also small. In addition, since the baluns $L_{2a}$, $L_{2b}$, and $L_{2c}$ are connected in series with each other, the total distributed capacitance of the baluns $L_{2a}$, $L_{2b}$, and $L_{2c}$ is further decreased. Total impedance can thus be kept high even in the low frequency range of 10 kHz to several megahertz.

Furthermore, the total inductance of the baluns $L_{2a}$, $L_{2b}$, and $L_{2c}$ is given as $L_{2a} + L_{2b} + L_{2c}$, since they are connected in series with each other. A high total inductance is thus guaranteed.

Assume that the following values are given for the balun $L_2$ shown in Fig. 1:

Inductance $L_2 = 100$ mH

Distributed capacitance $C_{L2} = 10$ pF

If the baluns $L_{2a}$, $L_{2b}$, and $L_{2c}$ are to obtain the same inductance as that of the balun $L_2$ (Fig. 1), for example, if

$L_{2a} = L_{2b} = L_{2c} = 33$ mH then

$L_{2a} + L_{2b} + L_{2c} \doteqdot 100$ mH

Distributed capacitances $C_{L2a}$, $C_{L2b}$, and $C_{L2c}$ of the baluns $L_{2a}$, $L_{2b}$, and $L_{2c}$ in the line filter of the modification are given as:

$C_{L2a} = C_{L2b} = C_{L2c} = 3$ pF When the total distributed capacitance is defined as $C_L$, the following relation is established:

$1/C_L = 1/C_{L2a} + 1/C_{L2b} + 1/C_{L2c}$ Therefore

$C_L = 1$ pF

In order to decrease the leakage current $I_L$ in the line filter described above, the capacitances of the Y capacitors must be decreased, and the inductances of the baluns $L_{2a}$, $L_{2b}$, and $L_{2c}$ must be increased. In this case, the total impedance can be increased since the balun $L_2$ (Fig. 1) is divided into the baluns $L_{2a}$, $L_{2b}$, and $L_{2c}$ to decrease the distributed capacitance thereof. The desired attenuation can thus be obtained.

Since the balun $L_2$ is divided into the baluns $L_{2a}$, $L_{2b}$, and $L_{2c}$, the size of other components can be kept small while the predetermined capacitance is maintained, thus providing a compact line filter.

In addition, the division of the balun $L_2$ into the baluns $L_{2a}$, $L_{2b}$, and $L_{2c}$ allows the use of standard components, thereby decreasing manufacturing costs.

According to the embodiment described above, the first and second choke coils are constituted by baluns, and the inductance of the second balun is larger than that of the first balun. Therefore, the total capacitance of the Y capacitors can be kept low, and common mode noise can be eliminated without increasing the size of the choke coil.

According to the application of the present invention, the line filter is divided into a front stage containing the balun $L_1$ and a rear stage containing the balun $L_2$. The front stage is separated from the rear stage to prevent leakage of common mode noise from the load through the input terminals of the line filter.

According to the modification of the present invention, the balun $L_2$ is divided into the baluns $L_{2a}$, $L_{2b}$, and $L_{2c}$, which are connected in series with each other, thereby increasing the total inductance of the balun $L_2$, decreasing the leakage current, and providing the desired attenuation.

## Claims

1. A line filter to be used in an electronic apparatus having an AC input unit and a switching power source unit, comprising:

a first choke coil ($L_1$) inserted between lines (L, N) at an input side of said line filter;

a second choke coil ($L_2$) inserted between the lines (L, N) at a load side of said line filter;

7

first Y capacitors ($C_1$, $C_2$) inserted between the lines (L, N) and ground (G) at an output side of said first choke coil ($L_1$);

a first X capacitor ($C_{X1}$) inserted between the lines (L, N);

second Y capacitors ($C_3$, $C_4$) inserted between the lines (L, N) and ground (G) at an output side of said second choke coil ($L_2$); and

a second X capacitor ($C_{X2}$) inserted between the lines (L, N) at a load side of said second choke coil ($L_2$),

wherein said first and second choke coils ($L_1$, $L_2$) comprise baluns and said second choke coil ($L_2$) has an inductance larger than that of said first choke coil ($L_1$).

2. A line filter according to claim 1, characterized in that a total capacitance of said first Y capacitors ($C_1$, $C_2$) is larger than that of said second Y capacitors ($C_3$, $C_4$).

3. A line filter according to claim 1, characterized in that said filter is divided into a first stage containing said first choke coil ($L_1$) and a second stage containing said second choke coil ($L_2$) and said second Y capacitors ($C_3$, $C_4$), said first stage being spaced apart from said second stage.

4. A line filter according to claim 3, characterized in that a total capacitance of said first Y capacitors ($C_1$, $C_2$) is larger than that of said second Y capacitors ($C_3$, $C_4$).

5. A line filter according to claim 1, characterized in that said second choke coil ($L_2$) is constituted by a plurality of choke coils ($L_{2a}$, $L_{2b}$, $L_{2c}$) which are connected in series with each other.

6. A line filter according to claim 5, characterized in that said plurality of choke coils ($L_{2a}$, $L_{2b}$, $L_{2c}$) comprise baluns, respectively.

7. A line filter according to claim 6, characterized in that a total capacitance of said first Y capacitors ($C_1$, $C_2$) is larger than that of said second Y capacitors ($C_3$, $C_4$).

**Revendications**

1. Un filtre de ligne à utiliser dans un appareil électronique ayant une unité d'entrée courant alternatif et une unité de source de courant de commutation, comprenant :
   - une première bobine d'arrêt ($L_1$) insérée entre des lignes (L,N) d'un côté entrée dudit filtre de ligne;
   - une seconde bobine d'arrêt ($L_2$) insérée entre les lignes (L,N) d'un côté charge dudit filtre de ligne;
   - des premiers condensateurs Y ($C_1$, $C_2$) insérés entre les lignes (L, N) et la terre (G) d'un côté sortie de ladite première bobine d'arrêt ($L_1$);
   - un premier condensateur X ($C_{X1}$) inséré entre les lignes (L,N);
   - des seconds condensateurs Y ($C_3$, $C_4$) insérés entre les lignes (L, N) et la terre (G) d'un côté sortie de ladite seconde bobine d'arrêt ($L_2$); et
   - un second condensateur X ($C_{Xz}$) inséré entre les lignes (L,N) et la terre (G) d'un côté charge de ladite seconde bobine d'arrêt ($L_2$).
   - dans lequel lesdites première et seconde bobines d'arrêt ($L_1$, $L_2$) comprennent des baluns et ladite seconde bobine d'arrêt ($L_2$) a une impédance supérieure à celle de ladite première bobine d'arrêt ($L_1$).

2. Un filtre de ligne selon la revendication 1, caractérisé en ce qu'une capacité totale desdits premiers condensateurs Y ($C_1$, $C_2$) est supérieure à celle desdits seconds condensateurs Y ($C_3$, $C_4$).

3. Un filtre de ligne selon la revendication 1, caractérisé en ce que ledit filtre est divisé en un premier étage contenant ladite première bobine d'arrêt ($L_1$) et un second étage contenant ladite seconde bobine d'arrêt ($L_2$) et lesdits seconds condensateurs Y ($C_3$, $C_4$), ledit premier étage étant séparé dudit second étage.

4. Un filtre de ligne selon la revendication 3, caractérisé en ce qu'une capacité totale desdits premiers

condensateurs Y ($C_1$, $C_2$) est supérieure à celle desdits seconds condensateurs Y ($C_3$, $C_4$).

5. Un filtre de ligne selon la revendication 1, caractérisé en ce que ladite seconde bobine d'arrêt ($L_2$) est constituée par une pluralité de bobines d'arrêt ($L_{2a}$, $L_{2b}$, $L_{2c}$) qui sont connectées en série les unes aux autres.

6. Un filtre de ligne selon la revendication 5, caractérisé en ce que ladite pluralité de bobines d'arrêt ($L_{2a}$, $L_{2b}$, $L_{2c}$) comprennent respectivement des baluns.

7. Un filtre de ligne selon la revendication 6, caractérisé en ce qu'une capacité totale desdits premiers condensateurs Y ($C_1$, $C_2$) est supérieure à celle desdits seconds condensateurs Y ($C_3$, $C_4$).

## Ansprüche

1. Leitungsfilter zur Verwendung in einer elektronischen Vorrichtung mit einer Wechselstrom-Eingangseinheit und einer Schaltleistungsquelleneinheit, mit
   - einer ersten zwischen Leitungen (L, N) an einer Eingangsseite des Leitungsfilters angeordneten Drosselspule ($L_1$);
   - einer zweiten zwischen den Leitungen (L, N) an einer Lastseite des Leitungsfilters angeordneten Drosselspule ($L_2$);
   - zwischen den Leitungen (L, N) und Erde (G) an einer Ausgangsseite der ersten Drosselspule ($L_1$) angeordneten ersten Y-Kondensatoren ($C_1$, $C_2$);
   - einem zwischen den Leitungen (L, N) angeordneten ersten X-Kondensator ($C_{X1}$);
   - zwischen den Leitungen (L, N) und Erde (G) an einer Ausgangsseite der zweiten Drosselspule ($L_2$) angeordneten zweiten Y-Kondensatoren ($C_3$, $C_4$); und
   - einem zweiten zwischen den Leitungen (L, N) an einer Lastseite der zweiten Drosselspule ($L_2$) angeordneten zweiten X-Kondensator ($C_{X2}$); bei dem die erste und die zweite Drosselspule ($L_1$, $L_2$) Symmetrierglieder aufweisen und die zweite Drosselspule ($L_2$) eine größere Induktivität aufweist als die erste Drosselspule ($L_1$).

2. Leitungsfilter nach Anspruch 1, dadurch gekennzeichnet, daß die Gesamtkapazität der ersten Y-Kondensatoren ($C_1$, $C_2$) größer ist als die der zweiten Y-Kondesatoren ($C_3$, $C_4$).

3. Leitungsfilter nach Anspruch 1, dadurch gekennzeichnet, daß das Filter in eine die erste Drosselspule ($L_1$) enthaltende erste Stufe und eine die zweite Drosselspule ($L_2$) und die zweiten Y-Kondensatoren ($C_3$, $C_4$) enthaltende zweite Stufe unterteilt ist, wobei die erste Stufe von der zweiten Stufe beabstandet ist.

4. Leitungsfilter nach Anspruch 3, dadurch gekennzeichnet, daß die Gesamtkapazität der ersten Y-Kondensatoren ($C_1$, $C_2$) größer ist als die der zweiten Y-Kondensatoren ($C_3$, $C_4$).

5. Leitungsfilter nach Anspruch 1, dadurch gekennzeichnet, daß die zweite Drosselspule ($L_2$) aus mehreren miteinander in Reihe geschalteten Drosselspulen ($L_{2a}$, $L_{2b}$, $L_{2c}$) besteht.

6. Leitungsfilter nach Anspruch 5, dadurch gekennzeichnet, daß die mehreren Drosselspulen ($L_{2a}$, $L_{2b}$, $L_{2c}$) jeweils Symmetrierglieder aufweisen.

7. Leitungsfilter nach Anspruch 6, dadurch gekennzeichnet, daß die Gesamtkapazität der ersten Y-Kondensatoren ($C_1$, $C_2$) größer ist als die der zweiten Y-Kondensatoren ($C_3$, $C_4$).

# FIG. 1

# FIG. 2

# FIG. 3

# FIG. 4

# FIG. 5

# FIG. 6

# FIG. 7

# FIG. 8

EP 0 186 524 B1

# FIG. 9

# FIG. 10

# FIG. 11

# FIG. 12

# FIG. 13

# FIG. 14

# FIG. 15